# EUROPEAN PATENT APPLICATION

(11) **EP 4 425 565 A2**
(43) Date of publication of application: **04.09.2024**
(21) Application number: 24160704.3
(22) Date of filing: 29.02.2024
(51) Int. Cl.: H01L 29/06, H01L 21/04, H01L 29/423, H01L 29/78, H01L 21/336

(54) **METHOD OF MANUFACTURING SEMICONDUCTOR DEVICE AND SEMICONDUCTOR DEVICE**

(30) Priority: 02.03.2023 TW 112107652
(71) Applicant: Hon Hai Precision Industry Co., Ltd., 236038 New Taipei City (TW)
(72) Inventor: HUNG, Chia-Lung, 236038 New Taipei City (TW); HSIAO, Yi-Kai, 236038 New Taipei City (TW); KUO, Hao-Chung, 236038 New Taipei City (TW)
(74) Representative: Mewburn Ellis LLP

(57) **Abstract**

A method of manufacturing a semiconductor device includes providing a substrate, in which the substrate is SiC base. The substrate, from bottom to top, sequentially includes an N-type heavy doping base layer, an N-type light doping layer, a P-well region, and an N-type heavy doping layer. The substrate is etched by using a patterned mask to form a gate trench and a channel region defined by the gate trench. The channel region is shielded by the patterned mask. An ion implant is performed to the gate trench such that a shielding implant layer is formed on the bottom of the gate trench. An oxidation process is performed to the gate trench thereby forming a gate oxide layer. The oxidation rate at the bottom of the gate trench is faster than the oxidation rate at the sidewall of the gate trench. A semiconductor device is also provided.

## Description

### BACKGROUND

### Field of Invention

The present disclosure relates to a method of manufacturing semiconductor device and semiconductor device thereof.

### Description of Related Art

With the recent developments of electric power techniques such as solar electronic, vehicle electronic, and high frequency high power modules, the power density requirement for electric power devices is also increased. The large current transistors not only can be accomplished by enlarging device size, but also be accomplished by reducing the on-resistance (Ron).

### SUMMARY

An aspect of the disclosure provides a method of manufacturing a semiconductor device. The method includes providing a substrate, wherein the substrate is SiC base, and the substrate sequentially includes, from bottom to top, an N-type heavy doping base layer, an N-type light doping layer, a P-well region, and a N-type heavy doping layer. The substrate is etched using a patterned mask to form at least one gate trench and a channel region defined by the at least one gate trench, wherein the channel region is covered by the patterned mask. An ion implantation process is performed to the at least one gate trench to form a shielding implant layer at a bottom surface of the at least one gate trench. An oxidation process is performed to the at least one gate trench to form a gate oxide layer, wherein an oxidation rate at the bottom surface of the at least one gate trench is faster than an oxidation rate at a sidewall of the at least one gate trench. At least one gate electrode is formed in the at least one gate trench.

In some embodiments, ions utilized in the ion implantation process includes P, As, or Ar.

In some embodiments, the method further includes removing the patterned mask after the performing the ion implantation process to the at least one gate trench.

In some embodiments, the method further includes performing an annealing process after removing the patterned mask, in which the annealing process is performed in an inert gas environment at the temperature of about 1700 Celsius degrees for about 30 minutes.

In some embodiments, etching the substrate to form at least one gate trench is performed such that the sidewall of the at least one gate trench has an inclined angle, in which the inclined angle is in a range from 75 degrees to 105 degrees.

In some embodiments, performing the ion implantation process to the at least one gate trench is performed vertical to the bottom surface of the at least one gate trench.

In some embodiments, performing the ion implantation process to the at least one gate trench is performed inclined towards the channel region.

Another aspect of the disclosure provides a semiconductor device. The semiconductor device includes a channel region disposed on an N-type heavy doping base layer, the channel region sequentially includes, from the N-type heavy doping base layer, an N-type light doping layer, a P-well region, and a N-type heavy doping layer, wherein the channel region and the N-type heavy doping base layer are SiC base. The semiconductor device includes at least one gate electrode disposed on at least one sidewall of the channel region, wherein top surfaces of the gate electrode are coplanar with a top surface of the channel region, and at least one gate oxide layer covering sidewalls and bottom surfaces of the gate electrode, respectively, wherein a thickness of the gate oxide layer at the bottom surface of the gate electrode is not less than a thickness of the gate oxide layer at the sidewall of the gate electrode.

In some embodiments, a number of the at least one gate electrode and the at least one gate oxide layer is two, and the gate electrodes are disposed at opposite sides of the channel region.

In some embodiments, the semiconductor device includes two shielding implant layers disposed below the gate oxide layers, respectively, wherein a bottom width of each of the gate electrodes is equal to or less than a width of each of the shielding implant layers.

In some embodiments, a width of each of the gate oxide layers is equal to the width of each of the shielding implant layers.

In some embodiments, the width of each of the shielding implant layers is greater than a width of each of the gate oxide layers, and each of the shielding implant layers single side extends into the channel region below each of the gate oxide layers.

In some embodiments, a number of the at least one gate electrode and the at least one gate oxide layer is one, and the gate electrode continuously surrounds the channel region.

In some embodiments, the semiconductor device further includes a shielding implant layer disposed below the gate oxide layer, wherein a bottom width of the gate electrode is equal to or less than a width of the shielding implant layer.

In some embodiments, the gate oxide layer includes a first portion at the sidewall of the gate electrode and a second portion at the bottom surface of the gate electrode, a thickness of the first portion is in a range from 30 nm to 200 nm, and a thickness of the second portion is in a range from 30 nm to 400 nm.

The disclosure provides a method of manufacturing semiconductor device and semiconductor device thereof. The shielding implant layer is formed at the bottom of the gate trench by using the self-aligned ion implantation process. The shielding implant layer disposed below the gate electrode and the gate oxide layer can reduce the bottom electric field of the gate oxide layer, so the gate oxide layer would be much reliable due to the electric field applied on the gate oxide layer would be lower than the breakdown voltage of the gate oxide layer. Additionally, the oxidation rates at the sidewall and the bottom of the gate trench are not the same because of the self-aligned ion implantation process, so that the formed gate oxide layer has the bottom thickness not less than the sidewall thickness to further reduce the bottom electric field of the gate oxide layer of the semiconductor device having trench type gate.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.
Fig. 1 to Fig. 3 and Fig. 6 to Fig. 10 are cross-sectional views of different fabricating steps of forming a semiconductor device according to some embodiments of the disclosure.
Fig. 4 and Fig. 5 are top views of a fabricating step of forming a semiconductor device according to some embodiments of the disclosure.
Fig. 11 is a cross-sectional view of a semiconductor device according to some embodiments of the disclosure.
Fig. 12A to Fig. 12G are cross-sectional views of a semiconductor device according to different embodiments of the disclosure.

### DESCRIPTION OF THE EMBODIMENTS

Reference will now be made in detail to the present embodiments of the disclosure, examples of which are illustrated in the accompanying drawings. Wherever possible, the same reference numbers are used in the drawings and the description to refer to the same or like parts. It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items. It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present disclosure.

Furthermore, relative terms, such as "lower" or "bottom" and "upper" or "top", may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper", depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

In order to accomplish the requirement of high voltage high current transistor devices, the trench type transistor is the trend of the development of the high power transistors because of the lower on-resistance (Ron), comparing to the planar type transistor. However, the performance of the conventional trench type transistor is limited by only one side conductive or the large pitches between the trenches. Furthermore, another problem of the trench type transistor is that the oxide layer at the trench bottom leads to large electric field so that the reliability of the device performance is reduced. Typical solutions include implanting extra P-type dopants to control the electric field or thickening the oxide layer at the trench bottom. However, implanting extra P-type dopants would leads to additional JFET effect which influences the on-resistance, and thickening the oxide layer at the trench bottom needs additional process steps which increases the complication of the manufacturing processes.

Therefore, an aspect of the disclosure is to provide a trench type transistor that has multiple gates or continuous gate, to enlarge the on-current by reducing the on-resistance, and a self-aligned P-type dopant implantation is performed following the formation of the trench to reduce the electric field of the gate oxide layer at the trench bottom. Additionally, the implant region such as at the bottom of the trench has a faster oxidation rate, thus the thickness of the gate oxide layer is thicker than other portions to reduce the electric field of the gate oxide layer at the trench bottom, without adding additional process.

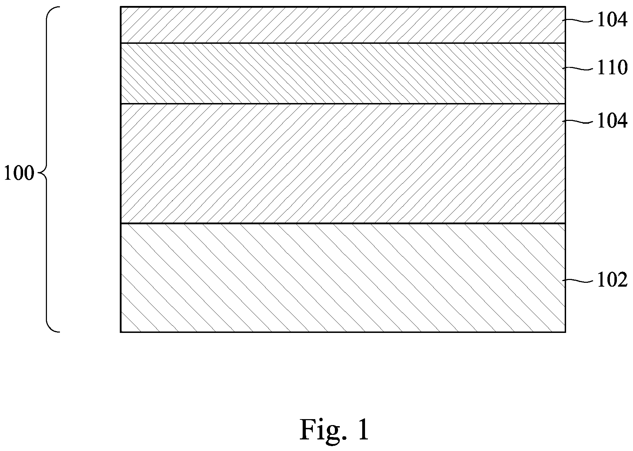

Reference is made to Fig. 1 to Fig. 3 and Fig. 5 to Fig. 10, which are cross-sectional views of different fabricating steps of forming a semiconductor device according to some embodiments of the disclosure. As shown in Fig. 1, an ion implantation process is performed to a substrate 100, such that a P-well region 110 is defined in the substrate 100. In some embodiments, the substrate 100 can be a semiconductor substrate such as a SiC substrate. The SiC is a semiconductor material that has wide energy band gap, so the SiC has greater breakdown voltage and lower current leakage. Additionally, the thermal conductivity of SiC material is better than the Si material, so that the SiC is suitable to be utilized in devices which are operated at high temperature environment such as transistors utilized in vehicles.

In some embodiments, the substrate 100 includes an N-type heavy doping base layer 102 and an N-type light doping layer 104 epitaxially grown on the N-type heavy doping base layer 102. In some embodiments, the doping concentration of the N-type heavy doping base layer 102 is greater than 5×10¹⁸/cm³, and the doping concentration of the N-type light doping layer 104 is between 5×10¹⁶/cm³ and 5×10¹⁷/cm³, depending on the manufacturing process and the design of the device. In some other embodiments, the N-type heavy doping base layer 102 and N-type light doping layer 104 can be formed by ion implantation processes.

In some embodiments, the implant depth of the P-well region 110 is lower than the top surface of the substrate 100, such that a portion of the N-type light doping layer 104 is remained above the P-well region 110 after the P-type dopant implantation is performed. In some embodiments, the doping concentration of the P-well region 110 is between 5×10¹⁵/cm³ and 1×10¹⁸/cm³.

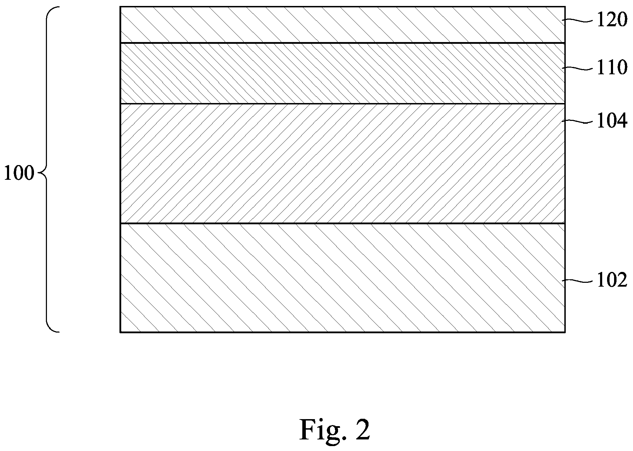

Referring to Fig. 2, an N-type implantation process is performed to the substrate 100 so that the portion of the N-type light doping layer 104 (as shown in Fig. 1) above the P-well region 110 becomes a N-type heavy doping layer 120. In some embodiments, the doping concentration of the N-type heavy doping layer 120 is greater than 5×10¹⁸cm³. In some embodiments, the thickness of the P-well region 110 is in a range from 0.3 µm to 1.3 µm, and the thickness of the N-type heavy doping layer 120 is in a range from 0.5 µm to 1.3 µm.

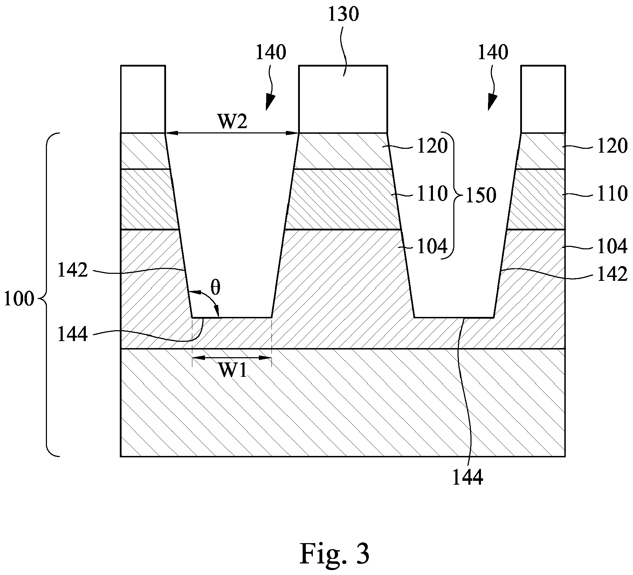

Referring to Fig. 3, a patterned mask 130 is formed on the substrate 100. The patterned mask 130 covers the regions that are pre-defined as channel regions, and the regions that are pre-defined as gates are exposed from the patterned mask 130. Then, an etching process is performed, including the etching process using dry etching or wet etching to remove the portions of substrate 100 that are not covered by the patterned mask 130. In some embodiments, the etching process stops at the N-type light doping layer 104, and portions of the P-well region 110 and the N-type heavy doping layer 120 uncovered by the patterned mask 130 are removed thereby defining one or more gate trenches 140 in the substrate 100. Portions of the P-well region 110 and the N-type heavy doping layer 120 protected by the patterned mask 130 and a portion of N-type light doping layer 104 serve as channel region 150.

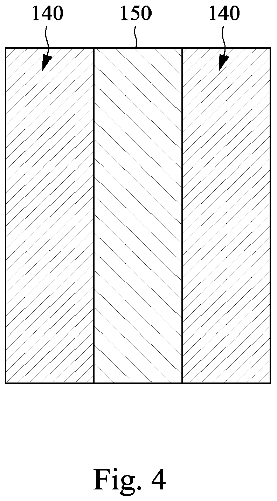

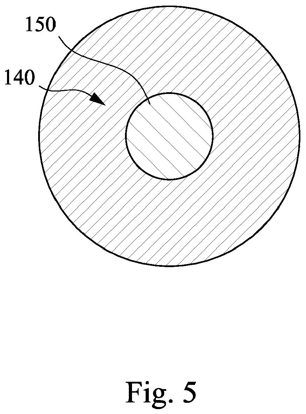

In some embodiments, as shown in Fig. 4, the number of the gate trenches 140 is two, and the gate trenches 140 are linear trenches that are parallelly arranged, and the gate trench 140 are arranged at opposite sides of the linear channel region 150. In some embodiments, as shown in Fig.5, the number of gate trench 140 is one, and the gate trench 140 is a continuous ring or polygon trench that surround the channel region 150.

Reference is made back to Fig. 3, according to the selected etching process, the sidewall 142 of the gate trench 140 can be a vertical sidewall or an inclined sidewall. In some embodiments, the angle θ between the sidewall 142 and bottom surface 144 of the gate trench 140 is in a range between 75 degrees to 105 degrees. In some embodiments, the bottom width W1 of the gate trench 140 is less than the top width of the gate trench 140 to reduce the punch through issue. In some other embodiments, the bottom width W1 of the gate trench 140 is greater than the top width of the gate trench 140 to enlarge the current path.

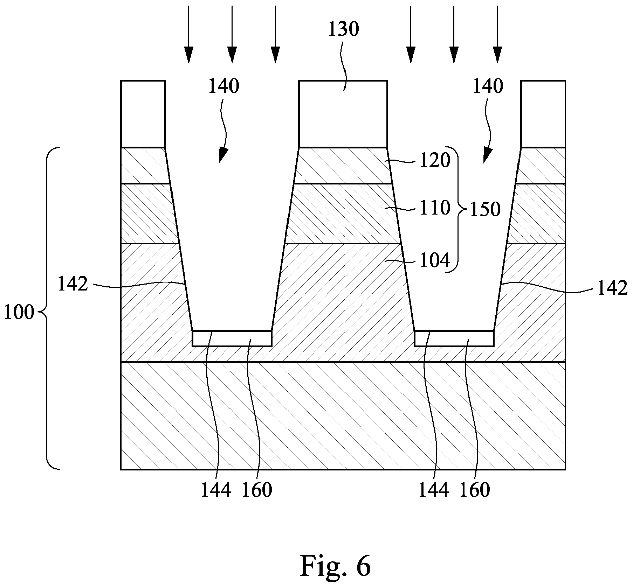

Referring to Fig. 6, an ion implantation process is performed to the gate trench 140 to form a shielding implant layer 160 at the bottom surface 144 of the gate trench 140. In some embodiments, an angle of performing the ion implantation process is vertical to the bottom surface 144 of the gate trench 140. Because the top surfaces of the channel region 150 are still protected by the patterned mask 130, so that the ions distributed to the sidewalls of the channel region 150 is limited. Further, an additional process can be performed on the sidewalls of the channel region 150, to prevent the sidewalls of the channel region 150 from being affected by the ion implantation process.

In some embodiments, the ion species selected in the ion implantation process are able to change the characteristic of the SiC base substrate 100. For example, the ions used in the ion implantation process can be P or other ion having larger atomic amount such as As, or noble gas such as Ar. After these selected ions are implanted, the bottom surface 144 of the gate trench 140 is bombarded by the selected ions and has a faster oxidation rate than the sidewall 142 of the gate trench 140, under the same oxidation conditions.

In some embodiments, the process of defining the gate trench 140 and the process of forming the shielding implant layer 160 use the same patterned mask 130, so the implantation process can be referred as a self-aligned implantation process, and the fabricating complication can be reduced.

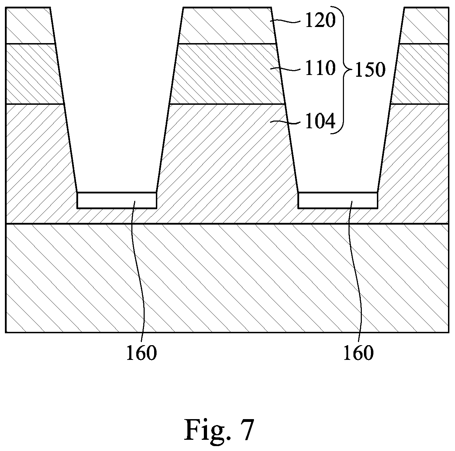

Then, as shown in Fig. 7, the patterned mask 130 is removed, an annealing process is performed in an inert gas environment to active the doped ions in the channel region 150 and the shielding implant layer 160. In some embodiments, the annealing process is performed at the temperature of about 1700 Celsius degrees for about 30 minutes. In some embodiments, the ions doped in the shielding implant layer 160 may diffuse and extend into the channel region 150 after the annealing process is performed.

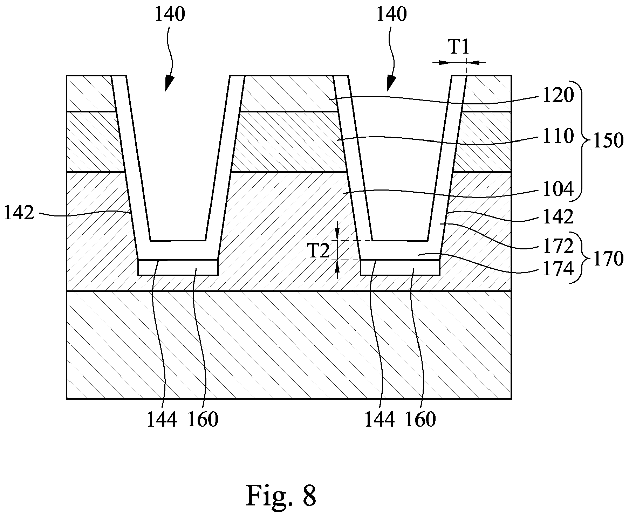

Referring to Fig. 8, an oxidation process is performed. The oxidation process includes performing an annealing process to the semiconductor structure that has been ion implanted and thermal annealed in an oxygen-containing environment. Because the doped ion concentration and/or the silicon lattice are different at the bottom surface 144 of the gate trench 140 and the sidewall 142 of the gate trench 140, the oxidation rates of the bottom surface 144 of the gate trench 140 and the sidewall 142 of the gate trench 140 are different even under the same oxidation conditions. For example, the oxidation rate at the bottom surface 144 of the gate trench 140 is significantly faster than the oxidation rate at the sidewall 142 of the gate trench 140, such that a gate oxide layer 170 formed by the single oxidation process has different thicknesses at the sidewall 142 of the gate trench 140 and the bottom surface 144 of the gate trench 140.

More particularly, the gate oxide layer 170 has a first portion 172 formed on the sidewall 142 of the gate trench 140 and a second portion 174 formed on the bottom surface 144 of the gate trench 140, in which the thickness T1 of the first portion 172 is less than the thickness T2 of the second portion 174. In other word, the first portion 172 of the gate oxide layer 170 on the sidewall of the channel region 150 has the thickness T1 less than the thickness T2 of the second portion 174 of the gate oxide layer 170 on the shielding implant layer 160. The gate oxide layer 170 having a thicker thickness at the bottom is benefit to reduce the electric field of the gate oxide layer 170 at the bottom of the ate trench 140.

In some other embodiments, the thickness T2 of the second portion 174 of the gate oxide layer 170 can be similar to the thickness T1 of the first portion 172. Namely, the thickness T2 of the second portion 174 of the gate oxide layer 170 is not less than the thickness T1 of the first portion 172.

In some embodiments, the thickness T1 of the first portion 172 of the gate oxide layer 170 is from 30 nm to 200 nm. If the thickness T1 of the first portion 172 is too thin such as thinner than 30 nm, the problem of product reliability is raised. If the thickness T1 of the first portion 172 is too thick such as thinner than 200 nm, the driving current of the device is reduced. The thickness T2 of the second portion 174 of the gate oxide layer 170 is from 30 nm to 400 nm. If the thickness T2 of the second portion 174 is too thin such as thinner than 30 nm, the problem of product reliability is raised. If the thickness T2 of the second portion 174 is too thick such as thinner than 400 nm, the driving current of the device is reduced.

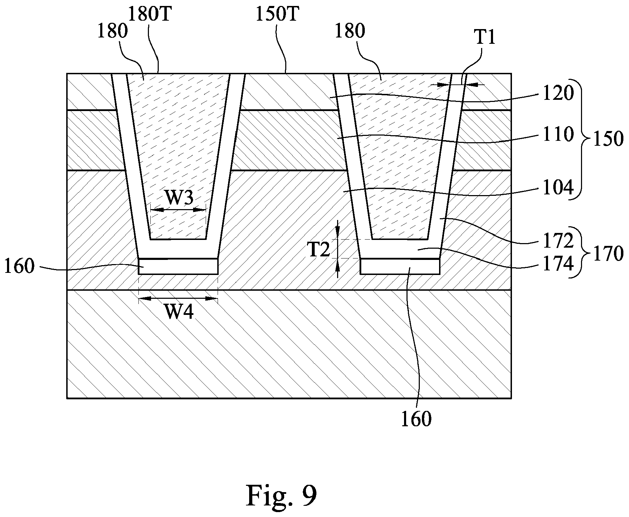

Then, referring to Fig. 9, a gate electrode material is filled in the gate trench 140 (as shown in Fig. 8), and a planarization process is performed to form the gate electrode 180 in the gate trench 140. The top surface 180T of the gate electrode 180 is coplanar with the top surface 150T of the channel region 150. In some embodiments, the gate electrode 180 may include a barrier layer, a work function adjusting layer, an adhesive layer, and a body metal layer (such as W, Cu, Co, Ru, etc.). The trench type gate electrode 180 can further reduce the on-resistance of the semiconductor device, comparing to the planar type transistor.

In some embodiments, the bottom width W3 of the gate electrode 180 can be greater than, equal to, or smaller than the width W4 of the shielding implant layer 160. The shielding implant layer 160 disposed below the gate electrode 180 and the gate oxide layer 170 can reduce the bottom electric field of the gate oxide layer 170, so the gate oxide layer 170 would be much reliable due to the electric field applied on the gate oxide layer 170 would be lower than the breakdown voltage of the gate oxide layer 170. The gate oxide layer 170 covers the bottom and the sidewall of the gate electrode 180, and the second portion 174 of the gate oxide layer 170 at the bottom of gate electrode 180 has the thickness T2 not less than the thickness T1 of the first portion 172 of the gate oxide layer 170 at the sidewall of the gate electrode 180.

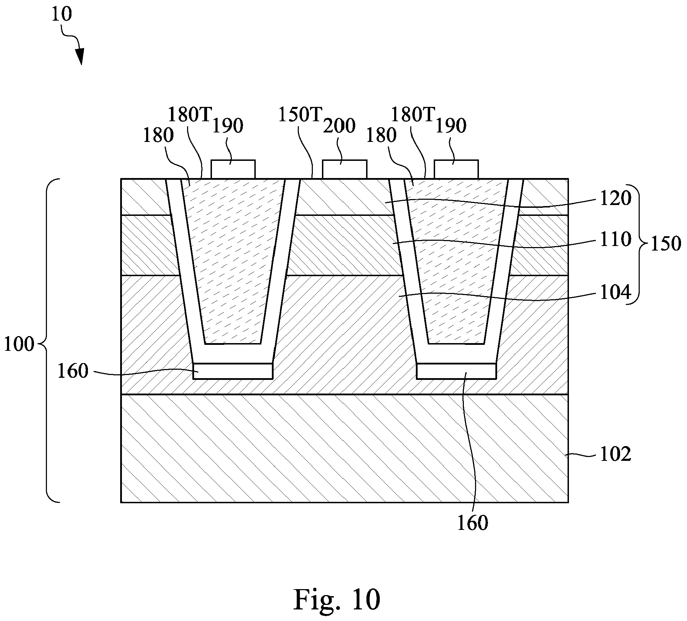

Then, referring to Fig. 10, a plurality of gate contacts 190 are formed on the top surface 180T of the gate electrode 180, and a plurality of source contact 200 are formed on the top surface 150T of the channel region 150, to continue the following backend processes. The N-type heavy doping base layer 102 can be served as the drain or common drain (if multiple transistors). The semiconductor device 10 includes the transistor is provided. By selectively applying voltage to the gate electrode 180, the channel region 150 is selectively conducted. The current conducting direction of the trench type gate electrode 180 is substantially same as the current conducting direction of the channel region 150.

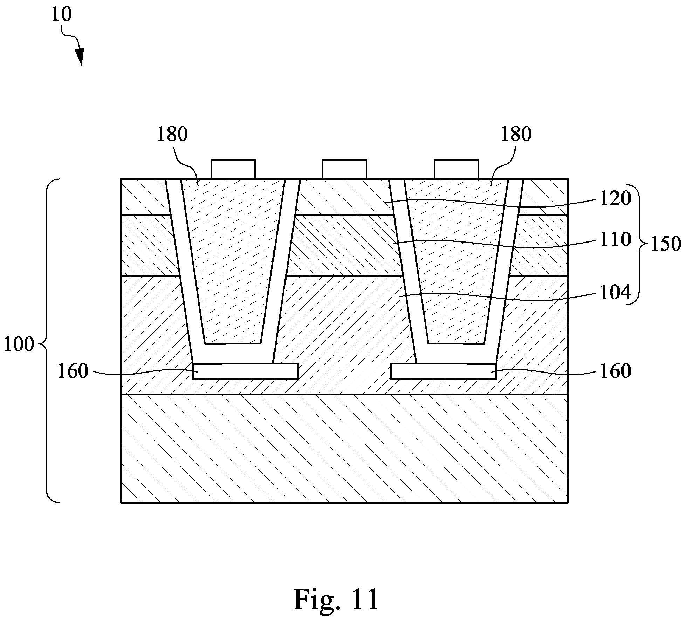

Reference is made to Fig. 11, which is a cross-sectional view of the semiconductor device according to some other embodiments of the disclosure. In some embodiments, if the implant angle of the process of performing the ion implantation process to the gate trench 140 to formed the shielding implant layer 160 at the bottom of the gate trench 140 as shown in Fig. 6 is not 90 degrees, and the implant angle is inclined towards the channel region 150, the formed shielding implant layer 160 would single side extend into the region between the gate trench 140 and exist below the gate electrode 180 and at the bottom corner of the channel region 150.

This shielding implant layer 160 formed by inclined implantation can further protect the gate oxide layer 170 at the bottom corner of the gate electrode 180 to further improve the reliability of the semiconductor device 10. The corona discharge is easily induced at the bottom corner of the gate electrode 180 so the bottom corner of the gate electrode 180 has higher electric field than other positions. The shielding implant layer 160 can be formed extended below the bottom of the channel region 150 by performing the inclined implantation, thus the problem of the reducing reliability of the semiconductor device 10 because of the corona discharge issue can be prevented.

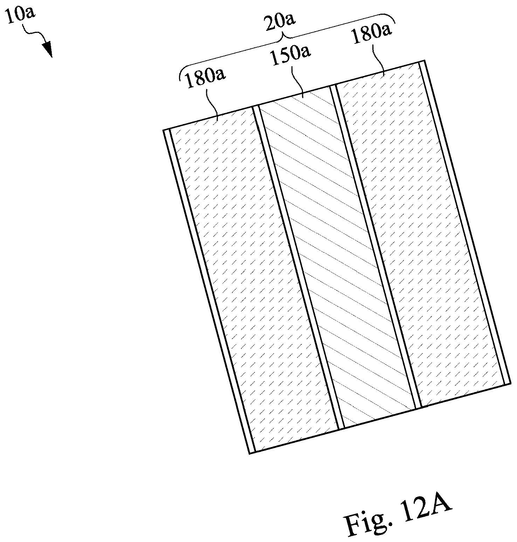

References is made to Fig. 12A to Fig. 12G, which are top views of the semiconductor devices according to different embodiments of the disclosure. As shown in Fig. 12A, the semiconductor device 10a includes a dual-gate trench type transistor 20a, in which the two gate electrodes 180a are linear and are parallelly arranged to co-control the channel region 150a.

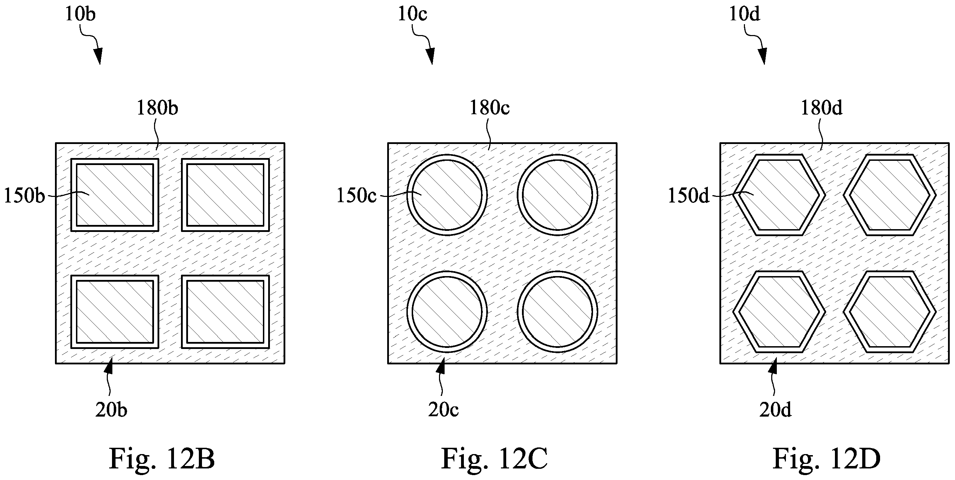

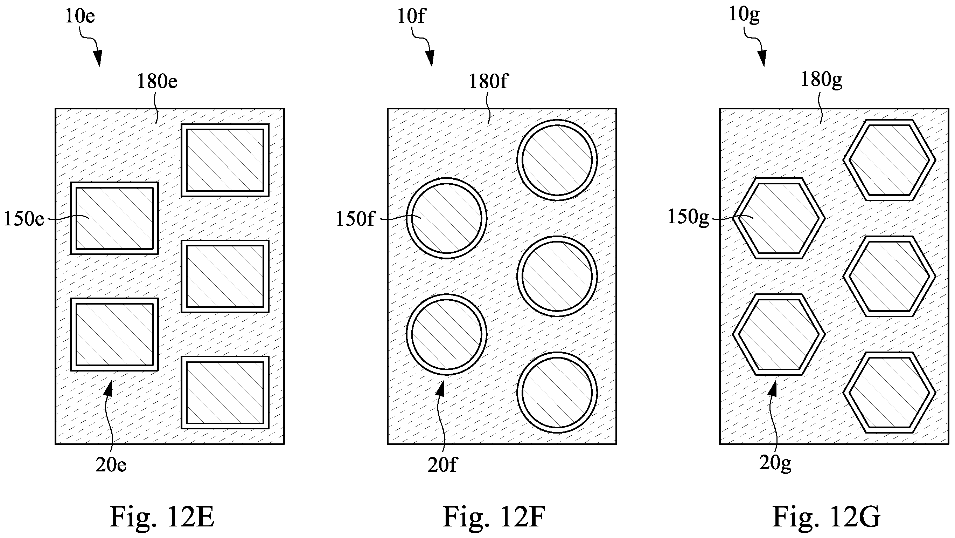

In the embodiments as shown in Fig. 12B to Fig. 12G. the semiconductor devices such as semiconductor devices 10b-10g include a continuous-gate trench type transistor such as transistors 20a-20g. The channel region such as the channel region 150b-channel region 150g is continuously surrounded by the gate electrode such as the gate electrode 180b-gate electrode 180g. In some embodiments, as shown in Fig. 12B to Fig. 12D, the channel region 150b-channel region 150d of the multiple transistors 20b-20d can be arranged in row and in column as a matric array. In some other embodiments, as shown in Fig. 12E to Fig. 12G, the channel region 150e-channel region 150e of the multiple transistors 20e-20g can be arranged in column, and the channel region 150e-channel region 150e of the multiple transistors 20e-20g in row can be misaligned.

The shape of the channel region 150b-channel region 150g continuously surrounded by the gate electrode 180b-gate electrode 180g can be circle or polygon. In some embodiments, as shown in Fig. 12B and Fig. 12E, the shape of the channel region 150b, channel region 150e in the transistors 20b, 20e can be a rectangle. In some embodiments, as shown in Fig. 12C and Fig. 12F, the shape of the channel region 150c, channel region 150f in the transistors 20c, 20c can be a circle. In some embodiments, as shown in Fig. 12D and Fig. 12G, the shape of the channel region 150d, channel region 150g in the transistors 20d, 20g can be a hexagon.

Either the dual-gate trench type transistor 20a or the continuous-gate trench type transistors 20b-20g has advantage of improving conducting current and reduce on-current resistance.

Accordingly, the disclosure provides a method of manufacturing semiconductor device and semiconductor device thereof. The shielding implant layer is formed at the bottom of the gate trench by using the self-aligned ion implantation process. The shielding implant layer disposed below the gate electrode and the gate oxide layer can reduce the bottom electric field of the gate oxide layer, so the gate oxide layer would be much reliable due to the electric field applied on the gate oxide layer would be lower than the breakdown voltage of the gate oxide layer. Additionally, the oxidation rates at the sidewall and the bottom of the gate trench are not the same because of the self-aligned ion implantation process, so that the formed gate oxide layer has the bottom thickness not less than the sidewall thickness to further reduce the bottom electric field of the gate oxide layer of the semiconductor device having trench type gate.

The method of manufacturing the semiconductor device of the disclosure includes using the self-aligned ion implantation process. Thus, the misalignment issue during the processes can be reduced, and the mask number utilized in the processes is reduced as well, the manufacturing complication and the cost can be reduced accordingly.

## Claims

1. A method of manufacturing a semiconductor device (10,10a,10b,10c,10d,10e,10f,10g) comprising:
providing a substrate (100), wherein the substrate (100) is SiC base, and the substrate (100) sequentially comprises, from bottom to top, an N-type heavy doping base layer (102), an N-type light doping layer (104), a P-well region (110), and a N-type heavy doping layer (120);
etching the substrate (100) using a patterned mask (130) to form at least one gate trench (140) and a channel region (150, 150a, 150b, 150c, 150d, 150e, 150f, 150g) defined by the at least one gate trench (140), wherein the channel region (150, 150a, 150b, 150c, 150d, 150e, 150f, 150g) is covered by the patterned mask (130);
performing an ion implantation process to the at least one gate trench (140) to form a shielding implant layer (160) at a bottom surface (144) of the at least one gate trench (140);
performing an oxidation process to the at least one gate trench (140) to form a gate oxide layer (170), wherein an oxidation rate at the bottom surface (144) of the at least one gate trench (140) is faster than an oxidation rate at a sidewall (142) of the at least one gate trench (140); and
forming at least one gate electrode (180, 180a, 180b, 180c, 180d, 180e, 180f, 180g) in the at least one gate trench (140).

2. The method of manufacturing a semiconductor device (10,10a,10b,10c,10d,10e,10f,10g) of claim 1, wherein ions utilized in the ion implantation process comprises P, As, or Ar.

3. The method of manufacturing a semiconductor device (10,10a,10b,10c,10d,10e,10f,10g) of any one of previous claims, further comprising removing the patterned mask (130) after the performing the ion implantation process to the at least one gate trench (140).

4. The method of manufacturing a semiconductor device (10,10a,10b,10c,10d,10e,10f,10g) of any one of previous claims, further comprising performing an annealing process after removing the patterned mask (130), wherein the annealing process is performed in an inert gas environment at a temperature of about 1700 Celsius degrees for about 30 minutes.

5. The method of manufacturing a semiconductor device (10,10a,10b,10c,10d,10e,10f,10g) of any one of previous claims, wherein etching the substrate (100) to form at least one gate trench (140) is performed such that the sidewall (142) of the at least one gate trench (140) has an inclined angle (*θ*), and the inclined angle (*θ*) is in a range from 75 degrees to 105 degrees.

6. The method of manufacturing a semiconductor device (10,10a,10b,10c,10d,10e,10f,10g) of any one of previous claims, wherein performing the ion implantation process to the at least one gate trench (140) is performed vertical to the bottom surface (144) of the at least one gate trench (140).

7. The method of manufacturing a semiconductor device (10,10a,10b,10c,10d,10e,10f,10g) of any one of previous claims, wherein performing the ion implantation process to the at least one gate trench (140) is performed inclined towards the channel region (150,150a,150b,150c,150d,150e,150f,150g).

8. A semiconductor device (10,10a,10b,10c,10d,10e,10f,10g) comprising:
a channel region (150,150a,150b,150c,150d,150e,150f,150g) disposed on an N-type heavy doping base layer (102), the channel region (150,150a,150b,150c,150d,150e,150f,150g) sequentially comprising, from the N-type heavy doping base layer (102), an N-type light doping layer (104), a P-well region (110), and a N-type heavy doping layer (120), wherein the channel region (150,150a,150b,150c,150d,150e,150f,150g) and the N-type heavy doping base layer (102) are SiC base;
at least one gate electrode (180,180a,180b,180c,180d,180e,180f,180g) disposed on at least one sidewall of the channel region (150,150a,150b,150c,150d,150e,150f,150g), wherein a top surface (180T) of the gate electrode (180,180a,180b,180c,180d,180e,180f,180g) is coplanar with a top surface (150T) of the channel region (150,150a,150b,150c,150d,150e,150f,150g); and
at least one gate oxide layer (170) covering a sidewall and a bottom surface of the gate electrode (180, 180a, 180b, 180c, 180d, 180e, 180f, 180g), wherein a thickness of the gate oxide layer (170) at the bottom surface of the gate electrode (180,180a,180b,180c,180d,180e,180f,180g) is not less than a thickness of the gate oxide layer (170) at the sidewall of the gate electrode (180,180a,180b,180c,180d,180e,180f,180g).

9. The semiconductor device (10,10a,10b,10c,10d,10e,10f,10g) of claim 8, wherein a number of the at least one gate electrode (180,180a) and the at least one gate oxide layer (170) is two, and the gate electrodes (180,180a) are disposed at opposite sides of the channel region (150,150a).

10. The semiconductor device (10,10a,10b,10c,10d,10e,10f,10g) of any one of claims 8-9, further comprising two shielding implant layers (160) disposed below the gate oxide layers (170), respectively, wherein a bottom width of each of the gate electrodes (180,180a) is equal to or less than a width of each of the shielding implant layers (160).

11. The semiconductor device (10,10a,10b,10c,10d,10e,10f,10g) of any one of claims 8-10, wherein a width of each of the gate oxide layers (170) is equal to the width of each of the shielding implant layers (160).

12. The semiconductor device (10,10a,10b,10c,10d,10e,10f,10g) of any one of claims 8-11, wherein the width of each of the shielding implant layers (160) is greater than a width of each of the gate oxide layers (170), and each of the shielding implant layers (160) single side extends into the channel region (150,150a) below each of the gate oxide layers (170).

13. The semiconductor device (10,10a,10b,10c,10d,10e,10f,10g) of any one of claims 8-12, wherein a number of the at least one gate electrode (180, 180b,180c,180d,180e,180f,180g) and the at least one gate oxide layer (170) is one, and the gate electrode (180, 180b,180c,180d,180e,180f,180g) continuously surrounds the channel region (150, 150b,150c,150d,150e,150f,150g).

14. The semiconductor device (10,10a,10b,10c,10d,10e,10f,10g) of any one of claims 8-13, further comprising a shielding implant layer (160) disposed below the gate oxide layer (170), wherein a bottom width of the gate electrode (180, 180b,180c,180d,180e,180f,180g) is equal to or less than a width of the shielding implant layer(160).

15. The semiconductor device (10,10a,10b,10c,10d,10e,10f,10g) of any one of claims 8-14, wherein the gate oxide layer (170) comprises a first portion (172) at the sidewall of the gate electrode (180, 180a, 180b, 180c, 180d, 180e, 180f, 180g) and a second portion (174) at the bottom surface of the gate electrode (180,180a, 180b,180c,180d,180e,180f,180g), a thickness (T1) of the first portion (172) is in a range from 30 nm to 200 nm, and a thickness (T2) of the second portion (174) is in a range from 30 nm to 400 nm.
